# EUROPÄISCHE PATENTSCHRIFT

(11) **EP 0 929 897 B1**
(45) Veröffentlichungstag und Bekanntmachung des Hinweises auf die Patenterteilung: **21.11.2001**
(21) Anmeldenummer: 97912037.5
(22) Anmeldetag: 29.09.1997
(51) Int. Cl.: G11C 8/00, G11C 7/00

(54) **DRAM**
DRAM
MEMOIRE VIVE DYNAMIQUE

(30) Priorität: 30.09.1996 DE 19640419
(43) Veröffentlichungstag der Anmeldung: 21.07.1999
(73) Patentinhaber: Infineon Technologies AG, 81669 München (DE)
(72) Erfinder: RIEGER, Johann, D-93077 Bad Abbach (DE)
(74) Vertreter: Zedlitz, Peter, Dipl.-Inf.
(86) Internationale Anmeldenummer: DE9702233
(87) Internationale Veröffentlichungsnummer: WO9814949

(56) Entgegenhaltungen:
- EP-A- 0 165 612
- JP-A- 4 067 389
- US-A- 5 657 285
- "SYSTEM MEMORY ACCESS LATENCY REDUCTION WHEN CROSSING SINGLE IN LINE MEMORY MODULE/DUAL IN LINE MEMORY MODULE BOUNDARIES" IBM TECHNICAL DISCLOSURE BULLETIN, Bd. 39, Nr. 4, 1.April 1996, Seite 151/152 XP000587455
- PATENT ABSTRACTS OF JAPAN vol. 016, no. 281 (P-1375), 23.Juni 1992 & JP 04 074378 A (NEC CORP), 9.März 1992,

## Beschreibung

Die Erfindung betrifft ein DRAM (Dynamischer Speicher mit direktem Zugriff) mit einem in Blöcke aufgeteilten Adreßraum, bei dem Speicherzellen einzelner Blöcke durch ein von einem Controller geliefertes RAS-Signal (row address signal) aktivierbar sind.

Der Adreßraum von DRAMs ist bekanntlich in mehrere Blöcke aufgeteilt, die physikalisch in einer Reihe nebeneinander und logisch in zwei Reihen nebeneinander angeordnet sind. Bei der logischen Betrachtungsweise bilden dann zwei übereinanderliegende Blöcke der beiden Reihen einen einzigen Block.

In logischer Betrachtungsweise weist so ein DRAM mit einer Speicherkapazität von 4 Megabit (4 M DRAM) vier Blöcke auf, während ein 16 M DRAM acht Blöcke besitzt.

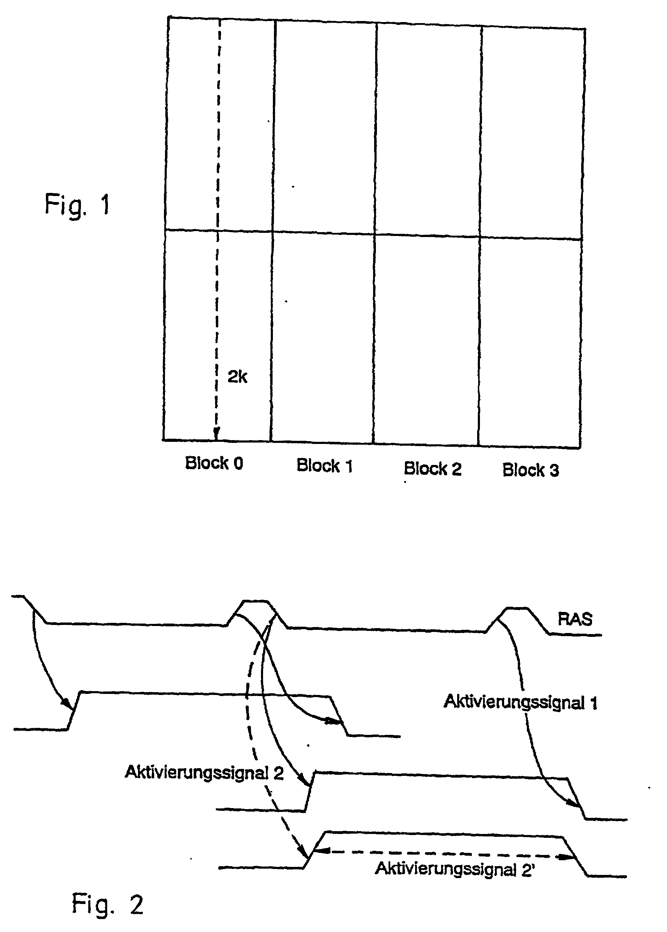

Es sei hierzu auf die Fig. 1 verwiesen, in der der logische Adreßraum mit vier Blöcken 0, 1, 2, 3 gezeigt ist.

Bei einem solchen DRAM besteht ein RAS-Zyklus aus dem Adressieren der einzelnen Zeilen, dem Bewerten der internen Daten der entsprechenden Speicherzellen und dauert bis zum Ausgleichen bzw. "equalize" der Bitleitung. Der RAS-Zyklus ist erst beendet, wenn der Zyklus des entsprechenden aktivierten Blocks abgeschlossen ist.

Dies ist in Einzelheiten in der Fig. 4 gezeigt, in der oben das vom Controller gelieferte RAS-Signal dargestellt ist. Aus diesem RAS-Signal wird insbesondere ein Wortleitungssignal WL abgeleitet, aus dem wiederum ein Bitleitungssignal BL gewonnen wird, wie dies durch entsprechende Pfeile angedeutet ist. CAS bedeutet ein "Spaltenadress-Signal" (column address signal), während DO den erhaltenen Datenausgang angibt. Wie nun aus der Fig. 4 zu ersehen ist, besteht die Zykluszeit T_{cycle} des RAS-Signals insbesondere aus der Zugriffszeit t_{RAC} und der Vorladezeit. Die Zugriffszeit beträgt beispielsweise 60 ns, während für die Zykluszeit T_{cycle} ein typischer Wert durch 110 ns gegeben ist.

Eine Verkürzung der Zykluszeit ist wünschenswert, da durch sie ein rascheres Auslesen des DRAMs erreicht wird. So erlaubt beispielsweise ein FPM-Betrieb (fast page mode) einen schnelleren Zugriff. Ein FPM-Betrieb beschränkt sich aber auf eine "page", nämlich die Spalten eines logischen Blockes (vergleiche den Strichpfeil in Fig. 1), was bei einem 4 M DRAM 0,05 % des gesamten Adreßraumes, nämlich 2 kBit von 4 Mbit bedeutet.

Patent Abstracts of Japan Bd. 16, Nr. 266 (P-1371), 16.06.92 und IBM Technical Disclosure Bulletin, Bd. 39, Nr. 4, 01.04.96, S. 151-152 beschreiben ein DRAM mit einem in Blöcke aufgeteilten Adressraum, wobei jeder Block mit einem separaten Zeilenadress-Signal gesteuert wird. Die fallende Flanke des einen Zeilenadress-Signals triggert ein erstes Aktivierungssignal und die fallende Flanke des anderen Zeilenadress-Signals triggert ein zweites Aktivierungssignal.

Aus EP-A-0 165 612 ist bekannt, durch eine zeitlich versetzte Aktivierung von separaten Blöcken eines DRAMs Stromspitzen zu reduzieren.

Es ist nun **Aufgabe** der vorliegenden Erfindung, ein DRAM zu schaffen, das sich durch eine besonders kurze Zykluszeit auszeichnet und damit einen noch schnelleren Datenzugriff erlaubt.

Diese Aufgabe wird bei einem DRAM der eingangs genannten Art mit den im Anspruch 1 augegebenen Merkmalen gelöst.

Bei dem erfindungsgemäßen DRAM, das, wie weiter unten näher erläutert wird, eine Zykluszeit von etwa 60 ns besitzt und daher auch als FRC-DRAM (fast RAS cycle) bezeichnet wird, kann man also einen oder mehrere der nicht aktivierten Blöcke aktivieren, bevor die Aktivitäten des mindestens einen zuvor ausgewählten Blockes abgeschlossen ist. Damit kann die Zykluszeit

des RAS-Signales wesentlich verkürzt und etwa auf die Hälfte vermindert werden. Diese Verkürzung der Zykluszeit wird insbesondere durch eine geringere Vorladezeit im RAS-Zyklus erreicht.

Wird wieder die übliche längere Vorladezeit in Kauf genommen, so kann ohne weiteres von einem normalen Modus des bestehenden DRAM zu dem FRC-Modus des erfindungsgemäßen DRAMs ohne gesondertes Umschalten übergegangen werden. Es ist also ohne Zeitverlust ein "Springen" zwischen dem normalen Modus und dem FRC-Modus möglich.

Während, wie oben erläutert wurde, bei dem FPM-Betrieb eine Adreßeinschränkung auf 0,05 % des gesamten Adreßraums vorliegt, ist diese Einschränkung bei dem erfindungsgemäßen FRC-DRAM wesentlich geringer: aufeinanderfolgende X-Adressen dürfen bei dem erfindungsgemäßen FRC-DRAM nicht im gleichen Speicherblock liegen. Das heißt, bei beispielsweise einem 4 M DRAM stehen nach einer X-Adresse, die beispielsweise im Block 0 liegt, die Blöcke 1 bis 3 zur Verfügung (vergleiche Fig. 1), was bedeutet, daß 75 % des Adreßraumes frei verfügbar sind. Bei einem 16 M DRAM ist dieser Anteil der frei verfügbaren Adressen sogar noch größer.

Bei dem erfindungsgemäßen DRAM werden die Aktivierungssignale für die einzelnen Blöcke unabhängig voneinander erzeugt. Dies kann beispielsweise dadurch geschehen, daß Beginn und Ende eines Aktivierungssignales jeweils aus dem RAS-Signal abgeleitet werden. Es ist aber auch möglich, beispielsweise nur den Beginn des Aktivierungssignales aus dem RAS-Signal abzuleiten und dann das Ende des Aktivierungssignales durch einen internen Zeitgeber einzustellen. Das "Restore Timing" wird in den einzelnen Speicherblöcken, also für diese Blöcke individuell erzeugt und nicht zentral wie bisher vorgegeben.

Gleiches gilt für Ansteuerspannung und Decoderspannung der Wortleitungen.

Wenn ein erfindungsgemäßes DRAM beispielsweise vier unabhängige Blöcke besitzt, also beispielsweise ein 4 M DRAM vorliegt, so kann eine niederwertige X-Adresse zur Blockauswahl herangezogen werden. Damit kann die Wahrscheinlichkeit, daß zwei aufeinanderfolgende Adressen im gleichen Block liegen, deutlich reduziert werden. In der Praxis wird ohnehin auf einen großen Teil der Adressen sequentiell zugegriffen, so daß die Adressen eines gleichen Blockes kaum nacheinander auftreten.

Wenn der Controller zwei verschiedene Zeitsteuerungen (timings) verwendet, die abhängig von der Entfernung von der letzten Zugriffsadresse arbeiten, so kann ohne weiteres erreicht werden, daß nicht nacheinander ein Zugriff auf den gleichen Block erfolgt. Gleiches kann auch durch entsprechende Abspeicherung eines zusätzlichen Bits erzielt werden.

Das erfindungsgemäße DRAM erlaubt einen Zykluszeitgewinn bei vier Blöcken von etwa 55 % der Zykluszeit eines normalen DRAMS bei einem sequentiellen Zugriff, 67 % der Zykluszeit eines normalen DRAM bei einem statistischen Zugriff und etwa 60 % der Zykluszeit eines normalen DRAMs bei einem praktischen Einsatz.

Da bei dem erfindungsgemäßen DRAM die Aktivierungssignale aus dem RAS-Signal abgeleitet werden, ist ein "CAS-before-RAS-Modus" nicht möglich.

Nachfolgend wird die Erfindung anhand der Zeichnung näher erläutert. Es zeigen:
- Fig. 1: ein Schema für den logischen Adreßraum eines 4 M DRAMs,
- Fig. 2: den Verlauf von Aktivierungssignalen 1 und 2 bei dem erfindungsgemäß DRAM, und
- Fig. 3: den Verlauf verschiedener Signale bei dem bestehenden DRAM.

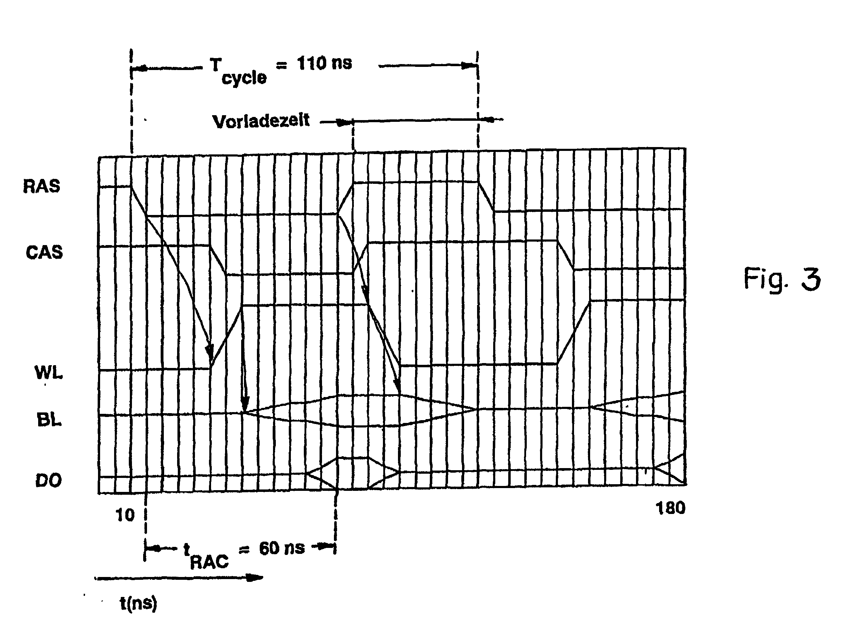

Die Fig. 3 und 1 sind bereits eingangs näher erläutert worden. Es sei aber angemerkt, daß die Fig. 1 den logischen Adreßraum bei dem bestehenden DRAM und bei dem erfindungsgemäßen DRAM wiedergibt.

Wie in Fig. 2 gezeigt ist, werden aus dem RAS-Signal Aktivierungssignale 1 und 2 abgeleitet, wobei Beginn und Ende der Aktivierungssignale 1 und 2 jeweils aus den Impulsen des RAS-Signales gewonnen werden. Alternativ kann, wie bereits oben erläutert wurde, jedoch auch nur der Beginn eines Aktivierungssignales aus dem RAS-Signal abgeleitet werden, während das Ende dieses Aktivierungssignales durch einen internen Zeitgeber des DRAMs vorgegeben ist. Dies ist in Fig. 2 für ein Aktivierungssignal 2' durch Strichpfeile angedeutet.

Wesentlich an der Erfindung ist also die blockweise Aktivierung mit unabhängigen Block-Aktivierungssignalen, die aus dem RAS-Signal vom Controller im DRAM erzeugt sind. Dadurch kann ein folgender Block aktiviert werden, bevor der vorliegende Block deaktiviert ist.

Während in dem Ausführungsbeispiel der Fig. 2 jeweils zwei Aktivierungssignal einander überlappen, ist es sogar auch möglich, so daß eine Überlappung von drei Aktivierungssignalen vorliegen kann. Es muß lediglich sichergestellt sein, daß diese Aktivierungssignale zeitlich nacheinander von verschiedenen Blöcken zugeführt sind.

## Patentansprüche

1. DRAM mit einem in Blöcke aufgeteilten Adressraum, bei dem die einzelnen Blöcke mittels RAS-Signal separat aktivierbar sind,
**dadurch gekennzeichnet,**
**daß** die Aktivierungssignale für die verschiedenen Blöcke nacheinander in teilweiser zeitlicher Überlappung diesen Blöcken zuführbar sind, so daß die erhaltene Datenrate in Folge teilweise gleichzeitiger Aktivierung von mindestens zwei verschiedenen Blöcken gegenüber der Aktivierung jeweils nur eines Blocks erhöht ist, und
**daß** jeder einzelne Block (Block 0 bis Block 3) durch ein unabhängiges, aus dem einzigen RAS-Signal abgeleitetes Aktivierungssignal in der Weise aktivierbar ist, daß der Beginn und das Ende der Blockaktivierung durch das einzige RAS-Signal steuerbar sind.

2. DRAM nach Anspruch 1,
**dadurch gekennzeichnet,**
**daß** die Dauer der Aktivierungssignale aus dem RAS-Signal abgeleitet ist.

3. DRAM nach Anspruch 1,
**dadurch gekennzeichnet,**
**daß** die Dauer der Aktivierungssignale durch einen internen Zeitgeber geliefert ist.

4. DRAM nach einem der Ansprüche 1 bis 3,
**dadurch gekennzeichnet,**
**daß** die Vorladezeit des RAS-Signales wesentlich kürzer als dessen Zykluszeit (Tcycle) ist.

## Claims

1. DRAM having an address space divided into blocks, in which the individual blocks can be separately activated by means of an RAS signal,
**characterized**
**in that** the activation signals for the different blocks can be successively fed to these blocks with a partial temporal overlap, with the result that the data rate obtained is increased on account of partially simultaneous activation of at least two different blocks by comparison with the activation of in each case only one block, and
**in that** each individual block (Block 0 to Block 3) can be activated by an independent activation signal derived from the single RAS signal in such a way that the beginning and the end of the block activation can be controlled by the single RAS signal.

2. DRAM according to Claim 1,
**characterized**
**in that** the duration of the activation signals is derived from the RAS signal.

3. DRAM according to Claim 1,
**characterized**
**in that** the duration of the activation signals is supplied by an internal timer.

4. DRAM according to one of Claims 1 to 3,
**characterized**
**in that** the precharge time of the RAS signal is significantly shorter than the cycle time (Tcycle) thereof.

## Revendications

1. DRAM comportant une zone d'adresses qui est subdivisée en blocs et dans laquelle les blocs individuels peuvent être activés séparément au moyen de signaux RAS, **caractérisée en ce que** les signaux d'activation pour les divers blocs peuvent être envoyés l'un après l'autre en chevauchement partiel dans le temps à ces blocs, si bien que le débit de données obtenu est augmenté à la suite de l'activation partiellement simultanée d'au moins deux blocs différents par rapport à l'activation de chaque fois seulement un bloc, et **en ce que** chaque bloc individuel (bloc 0 à bloc 3) peut être commandé par un signal d'activation indépendant, dérivé du seul signal RAS, de telle manière que le début et la fin de l'activation de blocs peuvent être commandés par le seul signal RAS.

2. DRAM suivant la revendication 1, **caractérisée en ce que** la durée des signaux d'activation est déduite du signal RAS.

3. DRAM suivant la revendication 1, **caractérisée en ce que** la durée des signaux d'activation est fournie par une horloge interne.

4. DRAM suivant l'une des revendications 1 à 3, **caractérisée en ce que** la durée de précharge du signal RAS est sensiblement plus brève que sa durée T_{cycle} de cycle.
